# EUROPÄISCHE PATENTSCHRIFT

(11) **EP 0 309 877 B1**
(45) Veröffentlichungstag und Bekanntmachung des Hinweises auf die Patenterteilung: **28.04.1993**
(21) Anmeldenummer: 88115437.1
(22) Anmeldetag: 21.09.1988
(51) Int. Cl.: G11C 8/00, G11C 7/00

(54) **Speicheranordnung**
Memory device
Dispositif de mémoire

(30) Priorität: 30.09.1987 DE 3733012
(43) Veröffentlichungstag der Anmeldung: 05.04.1989
(73) Patentinhaber: Deutsche Thomson-Brandt GmbH, 78003 Villingen-Schwenningen (DE)
(72) Erfinder: Rufray, Jean Claude, D-7739 Brigachtal (DE)

(56) Entgegenhaltungen:
- EP-A- 0 188 059
- DE-A- 3 530 217
- IEEE JOURNAL OF SOLID STATE CIRCUITS, Band SC-21, Nr. 5, Oktober 1986, Seiten 649-654, New York, US; KIYOTO OHTA et al.: "A 1-Mbit DRAM with 33-MHz serial I/O ports"

## Beschreibung

Die Erfindung betrifft eine Speicheranordnung nach dem Oberbegriff des Anspruchs 1.

Bei der Wiedergabe von Fernsehsignalen ist es erwünscht, den von einem Sender übertragenen Datenstrom vor der Darstellung auf der Bildröhre zu bearbeiten, um z.B. Störungen zu beseitigen, zusätzliche Informationen darzustellen oder das wiedergegebene Bild in einem anderen Raster, in einem anderen Ausschnitt oder mit einer anderen Bildfolge wiederzugeben. Da die Übertragung und die Wiedergabe der Bilddaten dann nicht synchron erfolgt, ist eine Zwischenspeicherung erforderlich. Dabei tritt das Problem auf, daß eine sehr große Datenmenge zwischengespeichert werden muß und ein schneller Zugriff auf einzelne Daten vorhanden sein muß. Prinzipiell wäre es möglich, einen ersten Speicher vorzusehen, in dem der serielle Datenstrom des übertragenen Signals eingeschrieben wird und einen zweiten Speicher vorzusehen, aus dem die auf dem Bildschirm darzustellenden Signale ausgelesen werden. Zwischen dem Ausgang des ersten und dem Eingang des zweiten Speichers kann dann eine entsprechende Umordnung oder Signalverarbeitung vorgenommen werden. Dies ist jedoch aufwendig, da die benötigten Speicher jeweils Speicherplatz für ein vollständiges Fernsehbild benötigen.

Aus IEEE JOURNAL OF SOLID STATE CIRCUITS, Band SC-21, Nr. 5, Oktober 1986, Seiten 649-654, New York, US; KIYOTO OHTA et al.: "A 1-Mbit DRAM with 33-MHz Serial I/O Ports", ist eine Speicheranordnung bekannt, bestehend aus einem Speicher mit Zeilen und Spalten, einer ersten Adressbufferschaltung für die Zeilen und einer zweiten Adressbufferschaltung für die Spalten, sowie einem ersten Schieberegistor mit einem seriellen Eingang und einem seriellen Ausgang, welches mit einem parallelen Eingang und Ausgang des Speichers verbunden ist, sowie einem zweiten Schieberegister mit einem seriellen Eingang und einem seriellen Ausgang, welches mit dem parallelen Eingang und Ausgang des Speichers verbunden ist. Darin sind jedoch die Zeilen- oder Spaltenadressen für das zweite Schieberegister nicht unabhängig von den Zeilen- oder Spaltenadressen für das erste Schieberegister steuerbar.

Der Erfindung liegt die Aufgabe zugrunde, eine Speicheranordnung zu schaffen, bei der serielle Bilddaten mit verschiedenen Adressen unter Verwendung eines einzigen Speichers weitgehend unabhängig voneinander ein- und/oder ausgelesen werden können.

Diese Aufgabe wird bei einer Speicheranordnung nach dem Oberbegriff des Anspruchs 1 durch die im kennzeichnenden Teil angegebenen Merkmale gelöst.

Gemäß der Erfindung werden die Daten zunächst seriell in Schieberegister eingeschrieben und dann in Blöcken von z.B. 8 oder 12 bit parallel in Speicherplätze des Speichers übernommen oder aus diesem parallel in die Schieberegister übernommen und seriell aus diesen ausgegeben. Dabei besteht die Möglichkeit, in den Zeiträumen zwischen der Übernahme oder Ausgabe von Datenblöcken in das erste Schieberegister bzw. aus dem zweiten Schieberegister, das andere Schieberegister entsprechend zu aktivieren. Dementsprechend können in beiden Schieberegistern unterschiedliche Datenströme mit unterschiedlicher Taktrate fließen, ohne daß bei der Eingabe oder Ausgabe das jeweils andere Schieberegister gestört wird. Durch entsprechende Umschaltung der Schieberegister wird ferner die Möglichkeit eröffnet, gleichzeitig zwei unterschiedliche Datenströme einzuschreiben oder anszulesen. So kann z.B. ein Datenstrom einer Weiterverarbeitung zugeführt werden, indem z.B. nachträglich einige Bits geändert werden, und der andere Datenstrom gleichzeitig der Bildröhre zugeführt werden. Außerdem besteht die Möglichkeit, einen Datenstrom mit einer geringen Datenrate einzuschreiben und einen anderen Datenstrom mit höherer Datenrate zweimal oder mehrmals hintereinander auszulesen und dazustellen.

Weiterbildungen und vorteilhafte Ausführungsformen ergeben sich aus den Unteransprüchen. Die Erfindung wird nachfolgend anhand von Ausführungsbeispielen, die in den Zeichnungen dargestellt sind, näher erläutert.
- Fig. 1: zeigt eine Speicheranordnung nach dem Stand der Technik;
- Fig. 2: zeigt eine Speicheranordnung nach der Erfindung;
- Fig. 3: zeigt eine Weiterbildung der erfindungsgemäßen Speicheranordnung.

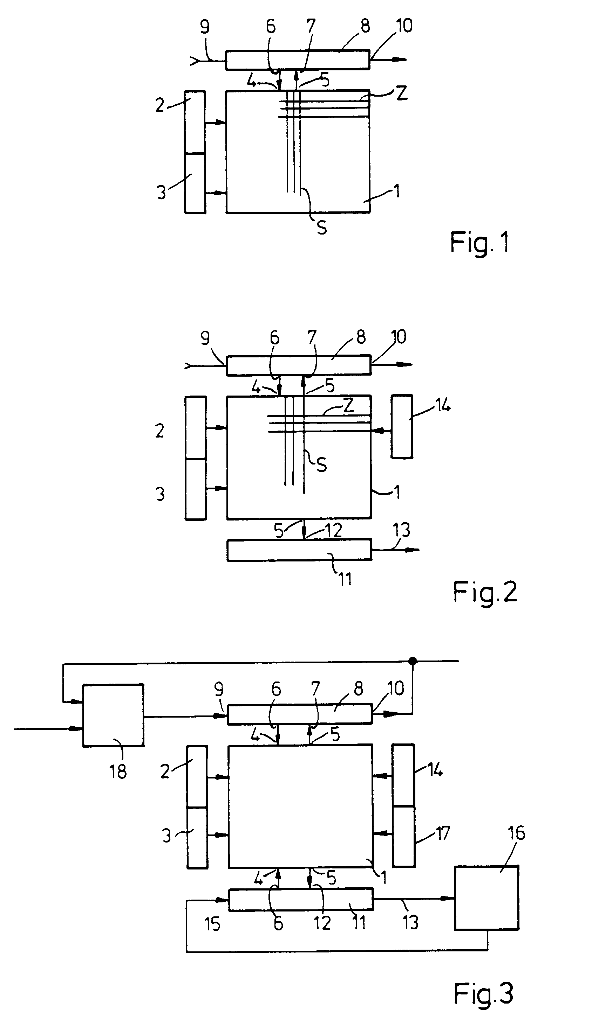

In Fig. 1 ist ein Speicher 1 mit z Zeilen und s Spalten dargestellt. Den Kreuzungspunkten der Zeilen und Spalten können mehrere Speicherplätze zugeordnet sein, um unterschiedliche Helligkeits- oder Farbwerte zu speichern. Die Speicherplätze sind durch einen ersten und zweiten Zähler 2, 3 adressierbar, die die getrennte Ansteuerung von Zeilen und Spalten ermöglichen. Die Eingänge 4 und Ausgänge 5 des Speichers 1 sind mit parallelen Eingängen 6 bzw. Ausgängen 7 eines Schieberegisters 8 verbunden. Das Schieberegister 8 besitzt ferner einen seriellen Eingang 9 und einen seriellen Ausgang 10. Bei dieser Speicheranordnung können über den seriellen Eingang 9 Daten in das Schieberegister 8 eingeschrieben werden, anschließend in den Speicher 1 übernommen werden und zu einem späteren Zeitpunkt wieder in das Schieberegister 8 übernommen und über den seriellen Ausgang 10 ausgegeben werden. Es leuchtet ein, daß dabei ein gleichzeitiges Einschreiben und Auslesen nicht möglich ist.

Die Speicheranordnung nach der Erfindung, wie sie in Fig. 2 dargestellt ist, enthält ein zweites Schieberegister 11, das mit dem Speicher 1 über zusätzliche parallele Eingänge 12 verbunden ist und einen seriellen Ausgang 13 umfaßt. Diesem Schieberegister ist ein dritter Adresszähler 14 zugeordnet, der es ermöglicht, unabhängig von dem Adresszähler 2 entsprechende Zeilen anzusteuern.

In Fig. 3 enthält das zweite Schieberegister 11 einen seriellen Eingang 15 und einen seriellen Ausgang 13, wobei der Ausgang 13 zu einer Bildröhre 16 führt. Außerdem ist ein Zähler 17 vorhanden, der zusammen mit dem Zähler 14 die unabhängige Adressierung von Zeilen und Spalten ermöglicht. Von der Bildröhre 16 ist eine Datenleitung an den seriellen Eingang 15 geführt, um dort entnommene Signale nach einer gegebenenfalls erforderlichen Korrektur zurückzuführen. Der serielle Ausgang 10 des ersten Schieberegisters 8 führt zu einem Datenprozessor 18, der zusammen mit dem eintreffenden seriellen Datenstrom eine Veränderung der Daten, z.B. eine Interpolation zwischen benachbarten Zeilen, durchführt. Der Ausgang des Prozessors 18 führt zu dem seriellen Eingang 9 des Schieberegisters 8.

Zwischen den parallelen Eingängen 7, 12 und Ausgängen 6 der Schieberegister 8, 11 und dem Speicher 1 können zusätzlich Pufferspeicher angeordnet sein.
Das erste Schieberegister 8 kann als Schreibschieberegister und das zweite Schieberegister als Leseschieberegister 11 dienen.
Dabei kann das Leseschieberegister 11 mit einer höheren Taktfrequenz, vorzugsweise einem ganzzahligen Vielfachen der Taktfrequenz des Schreibschieberegisters 8, getaktet sein.
Die Adress- zähler 2, 3, 14, 17 können auch wahlweise jedem der Eingänge 7, 12 und Ausgänge 6 der Schieberegister zuordbar sein.
Im Fall von Schieberegistern 8, 11, die eine ganze Zeile beinhalten, können auch nur Adresszähler 2, 14 für die Zeilen vorgesehen sein.

Insgesamt ermöglicht die erfindungsgemäße Speicheranordnung, bei dem gespeicherten Bild eine Unterdrückung von Störungen durchzuführen, indem z.B. extrem abweichende Bildsignale an die Bildsignale benachbarter Bildpunkte angeglichen werden. Auch eine Schärfeerhöhung kann durchgeführt werden, um bei gegebener Bildsignalbandbreite eine subjektive Verbesserung herbeizuführen. Ferner ist es möglich, in ein vorhandenes Bild Schrift oder ein weiteres Bild einzublenden. Außerdem können Ausschnitte aus dem Bild vergrößert werden. All diese Vorgänge, die nach dem Einschreiben des ursprünglichen Datenstroms mit den Bildinformationen durchgeführt werden, lassen sich zusätzlich zu dem Einschreiben und dem Auslesen auf dem Bildschirm realisieren. Es ist dazu lediglich erforderlich, durch Adressierung der Speicherplätze die Zuordnung zwischen diesen und den entsprechenden Schieberegistern herzustellen und die Daten in die Speicherplätze einzuschreiben oder auszulesen.
Zur Unterbringung des zusätzlichen Schieberegisters sowie der Zähler zur Ansteuerung der Speicheradressen wird verglichen mit dem von dem Speicher insgesamt belegten Platz der Chip-Fläche nur wenig zusätzlicher Platz belegt. Dadurch ist es möglich, die gesamte Speicheranordnung auf einem Chip unterzubringen, wohingegen sonst die doppelte Chipfläche benötigt würde.

## Patentansprüche

1. Speicheranordnung, bestehend aus einem Speicher (1) mit Zeilen (z) und Spalten (s), einem ersten Adresszähler (2) für die Zeilenansteuerung des Speichers und einem zweiten Adresszähler (3) für die Spaltenansteuerung des Speichers, sowie einem ersten Schieberegister (8) mit einem seriellen Eingang (9) und einem seriellen Ausgang (10), welches mit einem parallelen Dateneingang (4) und Datenausgang (5) des Speichers verbunden ist, sowie einem zweiten Schieberegister (11) mit einem seriellen Eingang (15) und einem seriellen Ausgang (13), welches mit dem parallelen Dateneingang und Datenausgang des Speichers verbunden ist, **dadurch gekennzeichnet**,
daß mittels eines dritten Adresszählers (14) die Zeilenadressen im Speicher für das zweite Schieberegister (11) unabhängig von den Zeilenadressen im Speicher für das erste Schieberegister (8) steuerbar sind.

2. Speicheranordnung nach Anspruch 1, **dadurch gekennzeichnet**, daß mittels eines vierten Adresszählers (17) die Spaltenadressen im Speicher für das zweite Schieberegister (11) unabhängig von den Spaltenadressen im Speicher für das erste Scheiberegister (8) steuerbar sind.

3. Speicheranordnung nach Anspruch 1 oder 2, **dadurch gekennzeichnet**, daß zwischen den parallelen Ein- (7, 12) und Ausgängen (6) der Schieberegister (8, 11) und dem Speicher (1) Pufferspeicher angeordnet sind.

4. Speicheranordnung nach einem oder mehreren der Ansprüche 1 bis 3, **dadurch gekennzeichnet**, daß das erste Schieberegister (8) als Schreibschieberegister und das zweite Schieberegister als Leseschieberegister (11) dient.

5. Speicheranordnung nach Anspruch 4, **dadurch gekennzeich**net, daß das Leseschieberegister (11) mit einer höheren Taktfrequenz, vorzugsweise einem ganzzahligen Vielfachen der Taktfrequenz des Schreibschieberegisters (8), getaktet ist.

6. Speicheranordnung nach einem oder mehreren der Ansprüche 1 bis 5, **dadurch gekennzeichnet**, daß die Adresszähler (2, 3, 14, 17) wahlweise jedem der Ein- (7, 12) und Ausgänge (6) der Schieberegister zuordbar sind.

7. Speicheranordnung nach Anspruch 1, **dadurch gekennzeichnet**, daß im Fall von Schieberegistern (8, 11), die eine ganze Zeile beinhalten, mir Adresszähler (2, 14) für die Zeilen vorgesehen sind.

## Claims

1. Storage arrangement consisting of a store (1) having rows (z) and columns (s), a first address counter (2) for the control of the rows of the store and a second address counter (3) for the control of the columns of the store as well as a first shift register (8) having a serial input (9) and a serial output (10) which is connected to a parallel data input (4) and data output (5) of the store, as well as a second shift register (11) having a serial input (15) and a serial output (13) which is connected to the parallel data input and data output of the store, characterised in that, the row addresses in the store for the second shift register (11) are controllable independently of the row addresses in the store for the first shift register (8) by means of a third address counter (14).

2. Storage arrangement in accordance with claim 1, characterised in that, the column addresses in the store for the second shift register (11) are controllable independently of the column addresses in the store for the first shift register (8) by means of a fourth address counter (17).

3. Storage arrangement in accordance with claim 1 or 2, characterised in that, buffer stores are arranged between the parallel inputs (7, 12) and outputs (6) of the shift registers (8, 11) and the store (1).

4. Storage arrangement in accordance with any one or more of the claims 1 to 3, characterised in that, the first shift register (8) serves as a writing shift register and the second shift register as a reading shift register (11).

5. Storage arrangement in accordance with claim 4, characterised in that, the reading shift register (11) is clocked at a higher clock frequency, preferably at an integral multiple of the clock frequency of the writing shift register (8).

6. Storage arrangement in accordance with any one or more of the claims 1 to 5, characterised in that, the address counters (2, 3, 14, 17) are allocatable selectively to each of the inputs (7, 12) and outputs (6) of the shift register.

7. Storage arrangement in accordance with claim 1, characterised in that, in the case of shift registers (8, 11) which comprise a whole row, only address counters (2, 14,) are provided for the rows.

## Revendications

1. Arrangement de mémoire composé d'une mémoire (7) avec des lignes (z) et des colonnes (s), d'un premier compteur d'adresses (2) pour l'excitation des lignes de la mémoire et d'un second compteur d'adresses pour l'excitation des colonnes de la mémoire ainsi que d'un premier registre à décalage (8) avec une entrée sérielle (9) et une sortie sérielle (10), qui est reliée à une entrée de données (4) parallèle et une sortie de données (5) parallèle de la mémoire, ainsi que d'un second registre à décalage (11) avec une entrée sérielle (15) et une sortie sérielle (13) qui est reliée à l'entrée de données parallèle et à la sortie parallèle de la mémoire, **caractérisé en ce** que les adresses de lignes dans la mémoire pour le second registre à décalage (11) peuvent être commandées à l'aide d'un troisième compteur d'adresses (14), indépendamment des adresses de lignes dans la mémoire pour le premier registre à décalage (8).

2. Arrangement de mémoire selon la revendication 1, **caractérisé en ce** que les adresses de colonnes dans la mémoire pour le second registre à décalage (11) peuvent être commandées à l'aide d'un quatrième comtpeur d'adresses (17), indépendamment des adresses de colonnes dans la mémoire pour le premier registre à décalage (8).

3. Arrangement de mémoire selon la revendication 1 ou 2, **caractérisé en ce** que des mémoires tampon sont placées entre les entrées parallèles (7, 12) et les sorties parallèles (6) des registres à décalage (8, 11) et la mémoire (1).

4. Arrangement de mémoire selon l'une ou plusieurs des revendications 1 à 3, **caractérisé en ce** que le premier registre à décalage (8) sert de registre de décalage d'écriture et le second registre à décalage de registre à décalage de lecture (11).

5. Arrangement de mémoire selon la revendication 4, **caractérisé en ce** que le registre à décalage de lecture (11) est rythmé avec une fréquence de cycle supérieure qui est de préférence un multiple entier de la fréquence de cycle du registre à décalage d'écriture (8).

6. Arrangement de mémoire selon l'une ou plusieurs des revendications 1 à 5, **caractérisé en ce** que les compteurs d'adresses (2, 3, 14, 17) peuvent être affectés au choix à chacune des entrées (7, 12) et sorties (6) des registres à décalage.

7. Arrangement de mémoire selon la revendication 1, **caractérisé en ce** que dans le cas de registres à décalage (8, 11) qui contiennent une ligne entière, il n'est prévu que des compteurs d'adresses (2, 14) pour les lignes.
